# FASCICULE DE BREVET EUROPEEN

(11) **EP 3 640 965 B1**
(45) Date de publication et mention de la délivrance du brevet: **12.05.2021**
(21) Numéro de dépôt: 19202990.8
(22) Date de dépôt: 14.10.2019
(51) Int. Cl.: H01H 71/46

(54) **DISPOSITIF DE MESURE ET APPAREIL DE COMMUTATION ÉLECTRIQUE**
MESSVORRICHTUNG UND ELEKTRISCHES SCHALTGERÄT
MEASURING DEVICE AND ELECTRICAL SWITCHING APPARATUS

(30) Priorité: 15.10.2018 FR 1859515
(43) Date de publication de la demande: 22.04.2020
(73) Titulaire: Schneider Electric Industries SAS, 92500 Rueil Malmaison (FR)
(72) Inventeur: JACOLIN, Brice, 38050 Grenoble Cedex 09 (FR); MARY, Michael, 38050 Grenoble Cedex 09 (FR); PINERO, Eric, 38050 Grenoble Cedex 09 (FR); DORMIGNY, Nicolas, 38050 Grenoble Cedex 09 (FR)
(74) Mandataire: Lavoix

(56) Documents cités:
- EP-A2- 0 872 867
- EP-A2- 1 744 428
- WO-A1-01/13488

## Description

La présente invention concerne un dispositif de mesure pour détecter l'état d'un appareil de commutation électrique. L'invention concerne également un appareil de commutation électrique comportant un tel dispositif de mesure Le document "EP 1 744 428 A2" décrit un dispositif de mesure pour détecter l'état d'un appareil de commutation électrique, selon le préambule de la revendication 1.

Les appareils de commutation et de protection électrique, tels que les disjoncteurs, sont généralement configurés pour interrompre la circulation d'un courant électrique lorsque l'intensité du courant dépasse un seuil de déclenchement. Certains seuils de déclenchement sont réglables par l'utilisateur, qui peut ainsi adapter la courbe de déclenchement de l'appareil en fonction des circonstances. Comme exemple de seuils réglables, on peut citer les seuils de déclenchement dits long retard et court retard, correspondant respectivement aux courants de surcharge et aux courants de court-circuit.

Dans certaines applications, il est souhaitable d'utiliser, en plus, un seuil d'autoprotection, afin d'assurer la protection de l'appareil lorsque le courant de court-circuit « I_{cc} » est supérieur à une limite de tenue électrodynamique maximale supportable par l'appareil.

Cela est particulièrement utile dans le cas des appareils de protection et de commutation utilisés dans des installations de distribution électrique à basse tension et à forte intensité. Dans de nombreux exemples, un tel appareil est placé en amont d'appareils de protection secondaires. Lorsqu'un court-circuit apparaît, l'appareil doit rester fermé suffisamment longtemps pour qu'un des appareils de protection secondaires situés en aval puisse se déclencher et isoler la partie de l'installation où s'est produit le court-circuit, pour autant que le courant de court-circuit ne dépasse pas le seuil d'autoprotection.

En pratique, la résistance électrodynamique maximale supportable par l'appareil n'est pas la même selon que l'appareil est dans l'état ouvert ou fermé. Le seuil d'autoprotection doit donc être adapté automatiquement en fonction de l'état de l'appareil. Il est donc nécessaire de pouvoir déterminer de façon sûre et fiable si l'appareil est dans un état ouvert ou fermé.

A cet effet, l'invention concerne un dispositif de mesure pour détecter l'état d'un appareil de commutation électrique, ce dispositif de mesure comportant
- armature comprenant une paroi principale ;
- une pièce tournante destinée à être couplée mécaniquement à un arbre de commande d'un appareil de commutation électrique ;
- un barreau mobile en rotation, de façon solidaire avec la pièce tournante, entre une première position et une deuxième position, le barreau s'étendant au travers d'une fente ménagée dans la paroi principale ;
- un capteur de position comportant un contact mobile adapté pour être poussé par le barreau dans une position rétractée lorsque le barreau est dans la première position et dans une position relâchée lorsque le barreau est dans la deuxième position ;
   ce dispositif de mesure étant caractérisé en ce qu'il comporte :
   - un dispositif de stabilisation comportant une base solidaire de l'armature et une lame élastique fixée à la base, la lame s'étendant le long de la fente et étant agencée pour exercer un effort de retenue sur le barreau lorsqu'il se trouve dans la première position.

Grâce à l'invention, le dispositif de mesure permet de déterminer de façon sûre et fiable si l'appareil de commutation est dans un état ouvert ou fermé. En particulier, le dispositif de stabilisation permet de limiter les vibrations intempestives du barreau susceptibles de conduire à une détection erronée de l'état de l'appareil.

Selon des aspects avantageux mais non obligatoires de l'invention, un tel dispositif de mesure peut incorporer une ou plusieurs des caractéristiques suivantes, prises isolément ou suivant toute combinaison techniquement admissible :
- La lame comporte une portion recourbée disposée en regard de la fente et formant un espace de retenue du barreau lorsque le barreau est dans la première position.
- La base est réalisée en polycarbonate.
- La base comporte un logement de réception à l'intérieur duquel est reçue une portion de la lame, le logement étant ouvert sur une première face de la base tournée vers la paroi principale de l'armature, l'ancrage de la lame étant réalisé au moyen de points d'appui faisant saillie à l'intérieur du logement depuis la base.
- L'extrémité encastrée de la lame comporte une portion repliée.
- La base comporte une surépaisseur formée en regard du logement de réception sur une deuxième face de la base opposée à la première face.
- La base comporte un mur de protection électriquement isolant faisant saillie par rapport à la base perpendiculairement à la paroi principale de l'armature.
- Le capteur de position est monté sur l'armature en étant aligné avec la base du dispositif de stabilisation, la base étant intercalée entre le capteur de position et la paroi principale.
- La lame comporte une portion d'extrémité libre disposée en regard de la fente et appuyant sur le barreau lorsque le barreau est dans la deuxième position.
- La lame est maintenue en contact avec le barreau lorsque le barreau se déplace entre la première position et la deuxième position.
- La lame est agencée pour exercer un effort de retenue sur le barreau lorsque le barreau est dans la deuxième position.

Selon un autre aspect, l'invention concerne un appareil de commutation électrique comportant des contacts électriques séparables, l'appareil comportant un arbre de commande couplé aux contacts électriques séparables pour commuter l'appareil entre un état électriquement ouvert et un état électriquement fermé. L'appareil de commutation comporte en outre un dispositif de mesure selon l'une quelconque des revendications précédentes, le dispositif de mesure étant couplé mécaniquement à l'arbre de commande pour détecter si l'appareil est dans l'état ouvert ou dans l'état fermé.

L'invention sera mieux comprise et d'autres avantages de celle-ci apparaîtront plus clairement à la lumière de la description qui va suivre d'un mode de réalisation d'un dispositif de mesure, donnée uniquement à titre d'exemple et faite en référence aux dessins annexés, dans lesquels :
- la figure 1 est une représentation schématique, selon une vue en perspective, d'un dispositif de mesure selon des modes de réalisation de l'invention associé à un appareil de commutation et/ou de protection électrique ;
- la figure 2 est une représentation schématique du dispositif de mesure de la figure 1 illustré selon une vue éclatée ;
- les figures 3 et 4 sont des vues de profil du dispositif de mesure de la figure 1, illustrées suivant la direction d'observation représentée par la flèche III sur la figure 1 et correspondant respectivement à deux positions différentes d'un barreau du dispositif de mesure ;
- les figures 5 et 6 sont des représentations schématiques, selon deux vues en perspective, d'un dispositif de stabilisation appartenant au dispositif de mesure de la figure 1.

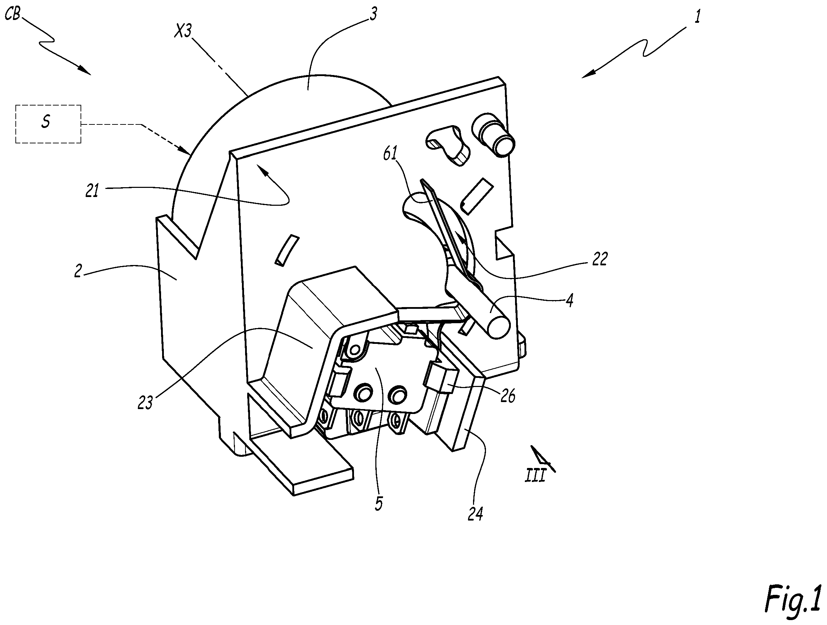

La figure 1 fait référence à un appareil de commutation et/ou de protection électrique, noté CB, tel qu'un disjoncteur, notamment un disjoncteur à coupure dans l'air avec des contacts séparables.

Selon des modes de mise en œuvre, l'appareil CB est raccordé à une ligne d'alimentation électrique, par exemple au sein d'une installation de distribution électrique, telle qu'une installation de distribution à forte intensité (par exemple supérieure à 500 ampères) et à basse tension (par exemple inférieure à 1000 volts). L'appareil CB est par exemple installé dans un tableau électrique.

L'appareil CB est commutable, sélectivement et réversiblement, entre un état électriquement ouvert, pour interrompre la circulation du courant électrique, et un état électriquement fermé, dans lequel la circulation du courant électrique est autorisée.

L'appareil CB est configuré pour interrompre la circulation du courant électrique dans la ligne d'alimentation lorsque l'intensité de ce courant électrique dépasse un seuil de déclenchement prédéfini.

A cet effet, l'appareil CB comporte un déclencheur, non illustré, tel qu'un déclencheur électronique.

Par exemple, un tel déclencheur électronique peut être implémenté par, ou associé à, une unité électronique de commande de l'appareil CB. Selon des exemples, l'unité électronique de commande peut comporter des circuits électroniques et/ou un microcontrôleur ou un microprocesseur programmable.

L'appareil CB comporte également un mécanisme de commutation, non illustré, adapté pour déplacer les contacts séparables en fonction d'un ordre de commande émis par le déclencheur, ou par un organe de commande manipulé par un utilisateur.

Selon des exemples, l'appareil CB peut comporter un ou plusieurs pôles, chaque pôle étant associé à une phase électrique du courant électrique. Ainsi, dans le cas d'un courant polyphasé, chaque pôle comporte des contacts séparables qui lui sont propres, mais qui sont néanmoins commandés conjointement par le mécanisme de commutation.

Par exemple, le mécanisme de commutation comporte un arbre de commande, noté S et communément nommé « arbre des pôles ».

L'arbre S est couplé aux contacts séparables pour leur transmettre un mouvement d'ouverture ou de fermeture, afin d'ouvrir ou fermer l'appareil, par exemple lorsque l'arbre S se déplace entre des positions prédéfinies correspondantes. Selon des exemples, l'arbre S est mobile en rotation autour de son axe longitudinal et se déplace entre les positions prédéfinies en tournant autour de son axe longitudinal.

L'appareil CB comporte également un dispositif de mesure 1 adapté pour déterminer l'état de l'appareil CB, notamment pour déterminer si l'appareil CB est dans un état ouvert ou fermé.

Un exemple du dispositif de mesure 1 est illustré aux figures 1 à 6.

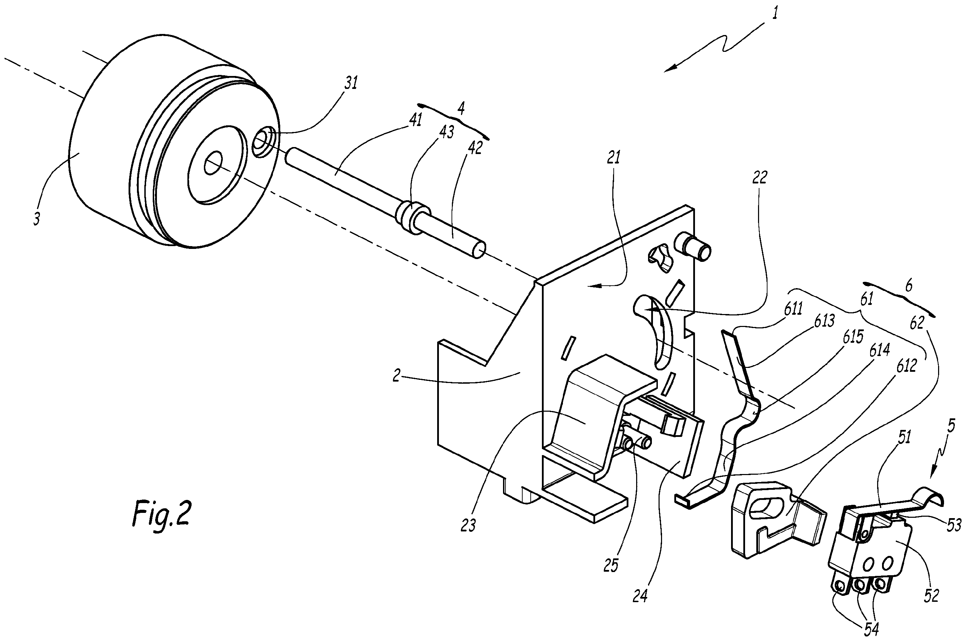

Comme illustré sur la figure 2, le dispositif 1 comporte une armature 2, une pièce tournante 3, un barreau 4, un capteur de position 5 et un dispositif de stabilisation 6.

L'armature 2 comprend une paroi principale 21, par exemple de forme plane. Une fente 22 traversante est ménagée dans la paroi principale 21.

Selon des exemples, l'armature 2 est réalisée en matière plastique, par exemple en polycarbonate.

Par exemple, l'armature 2 est fixée à l'intérieur d'un boîtier de l'appareil CB.

La pièce 3 est montée sur l'armature 2, par exemple sur une première face de la paroi 21. La pièce 3 est mobile en rotation autour d'un axe X3 perpendiculaire à la paroi 21. La pièce 3 est de préférence centrée sur l'axe X3.

Selon des exemples, la pièce 3 présente une forme de roue ou de cylindre. Par exemple, le diamètre de la pièce 3 est supérieur ou égal à 1cm et inférieur ou égal à 10cm.

Le barreau 4 est mobile en rotation autour de l'axe X3, entre une première position et une deuxième position, en se déplaçant en rotation de façon solidaire avec la pièce 3.

En d'autres termes, comme le barreau 4 est solidaire en rotation avec la pièce 3, tout mouvement de rotation de la pièce 3 correspond à un mouvement de rotation du barreau 4 autour de l'axe X3.

Le barreau 4 s'étend également au travers de la fente 22.

Selon des exemples, le barreau 4 est désaxé par rapport à l'axe de rotation X3 et s'étend selon une direction parallèle à l'axe X3.

Par exemple, une partie du barreau 4 est insérée à l'intérieur d'un logement traversant 31, tel qu'un perçage, formé dans la pièce 3.

Dans l'exemple illustré, le barreau 4 présente une forme de tige. Une première partie 41 du barreau 4 est au moins partiellement insérée dans le logement 31. Une deuxième partie 42 du barreau 4 traverse la fente 22.

Avantageusement, le barreau 4 peut comporter un élément intermédiaire 43, ici en forme d'anneau, qui fait office de butée pour empêcher une translation involontaire du barreau 4 le long de son axe longitudinal une fois qu'il est inséré dans le logement 31. Le logement 31 peut comporter une portion alésée qui reçoit l'élément intermédiaire 43.

De préférence, le barreau 4 est réalisé en métal, par exemple en acier.

Selon des modes de réalisation, le dispositif 1 comporte en outre un organe de rappel élastique, non illustré, pour ramener le barreau 4 vers l'une de ses première ou deuxième positions. Par exemple, l'organe de rappel est un ressort de torsion.

De préférence, l'organe de rappel est couplé à la pièce 3, le rappel du barreau 4 étant alors effectué indirectement en agissant sur la pièce 3.

Par exemple, l'organe de rappel ramène le barreau 4 vers sa deuxième position.

La pièce tournante 3 est en outre couplée mécaniquement à l'arbre S de l'appareil CB, par exemple au moyen d'un mécanisme de transmission, non illustré.

Selon des exemples de mise en œuvre, le mécanisme de transmission couple l'arbre S au barreau 4, par exemple par l'intermédiaire d'un levier. Dans ce cas, la partie 41 du barreau 4 peut dépasser à l'arrière de la pièce 3.

On comprend donc que, de façon générale, le mouvement de l'arbre S pour ouvrir ou fermer les contacts séparables de l'appareil CB, et donc pour commuter l'appareil CB entre les états ouvert ou fermé, entraîne un mouvement correspondant de la pièce 3 et du barreau 4.

Le dispositif 1 permet donc de déterminer indirectement l'état de l'appareil CB, en se basant sur la position de l'arbre S, notamment sur la position angulaire de l'arbre S, pour déterminer si les contacts séparables de l'appareil CB sont ouverts ou fermés.

Par exemple, la première position du barreau 4 correspond à un état fermé de l'appareil CB, et la deuxième position du barreau 4 correspond à un état ouvert de l'appareil CB.

Selon des modes de mises en œuvre, la pièce 3, aussi nommée « masselote », a un rôle de retardateur de l'arbre S lorsque ce dernier se déplace entre ses positions prédéfinies. A titre d'exemple illustratif et non nécessairement limitatif, la pièce 3, de par sa conformation, notamment sa forme ou la position de son centre de gravité, oppose une inertie qui permet de contrôler la durée du déplacement entre les deux positions pour que cette durée soit comprise dans un intervalle prédéfini.

Dans l'exemple illustré, la fente 22 présente une forme d'arc de cercle (ou de croissant) centré sur l'axe X3. Par exemple, la longueur de la fente (c'est-à-dire la longueur de l'arc de cercle) est choisie de manière à correspondre à la longueur de la course de déplacement du barreau 4 entre la première position et la deuxième position.

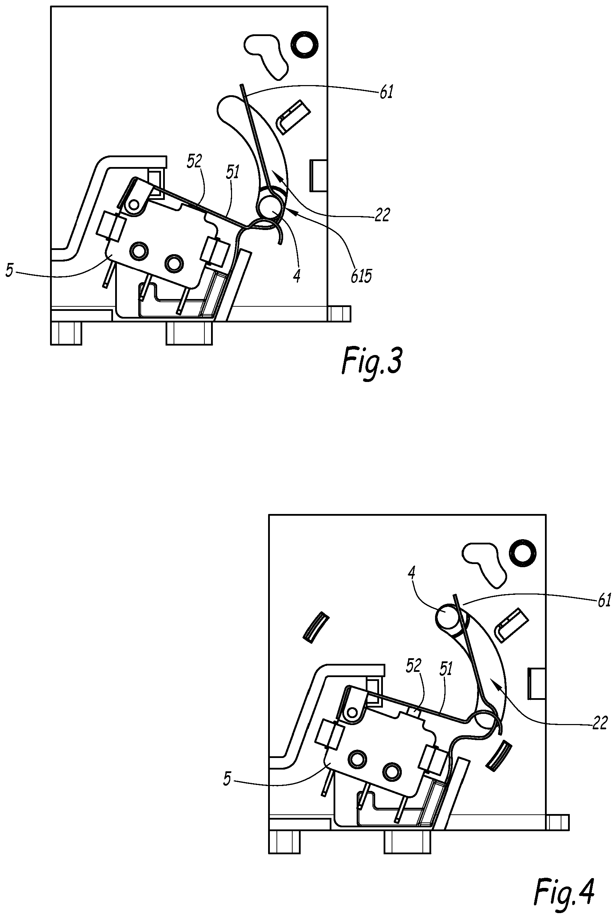

Par exemple, dans la première position, le barreau 4 est en position basse, au niveau d'une extrémité inférieure de la fente 22, comme illustré sur la figure 3. Dans la deuxième position, le barreau 4 est en position haute, au niveau d'une extrémité supérieure de la fente 22, comme illustré sur la figure 4.

Le capteur de position 5 est agencé pour mesurer la position du barreau 4, notamment pour détecter si le barreau 4 est dans la première position ou dans la deuxième position.

Selon des modes de mise en œuvre, le capteur de position 5 comporte un contact mobile 51 adapté pour être poussé par le barreau 4 dans une position enfoncée lorsque le barreau 4 est dans la première position, et relâché dans une position de repos lorsque le barreau 4 est dans la deuxième position. Par exemple le contact mobile 51 est relâché dès que le barreau 4 quitte la première position.

Selon des exemples, le contact mobile 51 du capteur 5 est une lame montée pivotante par rapport à un corps 52 du capteur 5. Le capteur 5 comporte également un bouton poussoir 53, ici intégré dans le corps 52.

La lame 51 comporte ici une portion d'extrémité bombée sur laquelle le barreau 4 appuie lorsqu'il est dans la première position.

Comme cela est montré sur les figures 3 et 4, la lame 51 appuie sur le bouton 53 uniquement lorsqu'elle est enfoncée et n'appuie pas sur le bouton 53 lorsqu'elle est relâchée.

Le capteur 5 comporte ici un connecteur électrique 54, par exemple pourvu de broches, permettant le raccordement du capteur 5 à une unité de commande de l'appareil CB, afin de fournir un signal de mesure représentatif de l'état du bouton 53, et donc représentatif de l'état enfoncé ou relâché du contact mobile 51.

De préférence, le capteur 5 est monté sur l'armature 2, par exemple sur une deuxième face de la paroi 21, cette deuxième face étant opposée à la première face de la paroi 21.

Selon des modes de réalisation, le déclencheur de l'appareil CB est programmé pour sélectionner automatiquement un seuil de déclenchement, dit seuil d'autoprotection, en fonction de la position du barreau 4 telle que détectée au moyen du capteur 5.

En d'autres termes, le seuil d'autoprotection est sélectionné automatiquement en fonction de l'état ouvert ou fermé de l'appareil CB.

Par exemple, un premier seuil de déclenchement prédéfini, noté DIN, pour « seuil de déclenchement instantané d'autoprotection », est sélectionné automatiquement lorsque le barreau 4 est détecté comme étant dans la première position. Un deuxième seuil de déclenchement, noté DINF, pour « seuil de déclenchement instantané d'autoprotection à la fermeture », est sélectionné automatiquement lorsque le barreau 4 est détecté comme étant dans la deuxième position.

Le dispositif de stabilisation 6 comporte une lame 61 et une base 62, ou boîtier 62. La base 62 est montée sur l'armature 2. La lame 61 est fixée à la base 62, par exemple en étant encastrée dans la base 62. La lame 61 s'étend le long de la fente 22 et est agencée pour exercer un effort de retenue sur le barreau 4 lorsqu'il se trouve dans l'un ou l'autre de la première position et de la deuxième position.

A cet effet, la lame 61 est de préférence élastique. Par exemple, la lame 61 est une lame métallique. Selon des exemples, la lame 61 est en acier inoxydable.

A titre d'exemple, l'épaisseur e61 de la lame 61 est inférieure ou égale à 2mm ou à 1,5mm. L'épaisseur e61 est ici constante sur toute la longueur de la lame 61.

Selon un exemple illustratif, l'effort de retenue exercé sur le barreau 4 par la lame 61 lorsque le barreau 4 est dans la première position est supérieur ou égal à 1 daN, de préférence supérieur ou égal à 1,8 daN. De préférence encore, cet effort est inférieur ou égal à 2,5 daN ou, alternativement, inférieur ou égal à 2,2 daN.

Selon des modes de mise en œuvre illustrés plus en détail aux figures 2, 5 et 6, la lame 61 comporte une première extrémité 611 libre, une deuxième extrémité 612 fixée à la base 62, une première partie 613 et une deuxième partie 614 reliées entre elles par une portion recourbée 615.

Par exemple, les parties 613 et 614 sont sensiblement droites et la portion recourbée 615 présente une forme arrondie en forme de U.

La lame 61 présente également une troisième partie 616 sensiblement droite et coudée par rapport à la partie 614. La troisième partie 616 se termine par la deuxième extrémité 612. La partie 613 se termine par la première extrémité 611.

Dans les exemples illustrés, les parties 613 et 314 s'étendent dans un plan vertical. Les faces principales de la lame s'étendent perpendiculairement à la paroi 21.

Selon des exemples, la deuxième extrémité 612 de la lame comporte une portion repliée.

Selon des modes de réalisation, l'extrémité libre 611 appuie sur le barreau lorsque le barreau est dans la deuxième position. On comprend donc que la première extrémité 611, ou tout au moins la portion de partie 613 située au voisinage de l'extrémité 611, est placée sensiblement au niveau de l'emplacement occupé par le barreau 4 lorsque ce dernier est dans la deuxième position.

Par ailleurs, la portion recourbée 615 est disposée en regard de la fente 22 et forme un espace de retenue du barreau 4 lorsque le barreau 4 est dans la première position.

Par exemple, comme illustré sur les figures 3 et 4, la première partie 613 s'étend le long de la fente 22. La première extrémité 611 est placée au niveau de l'extrémité supérieure de la fente 22 et la portion recourbée 615 est placée au niveau de l'extrémité inférieure de la fente 22.

De préférence, la lame 61 est décalée par rapport à la partie mobile 51 du capteur 5, par exemple décalée selon l'axe X3, de manière à éviter tout chevauchement entre la lame 61 et la partie mobile 51. La lame 61 et la partie mobile 51 sont néanmoins suffisamment proches de la paroi 21 pour être actionnées par le barreau 4.

Selon des exemples, la lame 61 est maintenue en contact avec le barreau 4 lorsque le barreau 4 se déplace entre la première position et la deuxième position, par exemple en glissant le long de la lame 61, en contact avec l'une des faces principales de la lame 61.

La lame 61, du fait de son élasticité, permet d'offrir un débattement qui n'entrave pas le déplacement du barreau 4 de la deuxième position (position haute, associée au seuil DINF) vers la première position (position basse, associée au seuil DIN).

Lorsque le barreau 4 est dans l'une ou l'autre des première et deuxième positions, grâce à l'effort de retenue exercé par la lame 61 sur le barreau 4 du fait de l'élasticité de la lame 61, le barreau 4 est maintenu en position de façon stable.

Pour déplacer le barreau 4 en vue de l'amener vers son autre position, un effort supérieur à l'effort de retenue doit être exercé sur le barreau 4. En pratique, le seuil d'effort de retenue est choisi suffisamment élevé pour que des vibrations parasites à l'intérieur de l'appareil CB ne soient pas suffisantes pour déplacer le barreau 4 en dehors de ses première ou deuxième positions. En revanche, un mouvement de la pièce 3 résultant d'un mouvement correspondant de l'arbre S est suffisant pour surmonter l'effort de retenue et ainsi déplacer le barreau 4 vers sa position opposée.

On comprend donc que le dispositif de stabilisation 6 réduit le risque d'oscillations non souhaitées du barreau 4 lorsque le barreau 4 est dans la première position. Dans ce mode de réalisation, les oscillations sont réduites lorsque le barreau 4 est dans l'une ou l'autre des première et deuxième positions. De telles vibrations sont, par exemple, causées par des forces électrodynamiques lorsque l'appareil CB est traversé par un courant élevé.

Par exemple, lorsque le barreau 4 est dans la première position, des vibrations du barreau 4 pourraient entraîner au moins temporairement un relâchement de la lame 51, et donc entraîner un relâchement du bouton 53, alors que l'arbre S n'aurait pas changé de position. Le capteur 5 retournerait alors une information erronée qui ne refléterait pas l'état véritable de l'appareil CB. Un seuil d'autoprotection inapproprié serait alors choisi, ce qui compromettrait le bon fonctionnement de l'installation électrique.

Grâce à l'invention, le dispositif de stabilisation 6 permet de limiter les vibrations intempestives du barreau 4 susceptibles de conduire à une détection erronée de l'état de l'appareil CB. Le dispositif de mesure 1 permet donc de déterminer, de façon sûre et fiable, si l'appareil CB est dans un état ouvert ou fermé.

Selon des modes de réalisation, la base 62 est réalisée en polymère, notamment en plastique, par exemple par moulage.

De préférence, la base 62 est réalisée en polycarbonate. Le polycarbonate permet de limiter les reprises d'humidité et augmente donc la durabilité de la base 62.

Selon des modes de mise en œuvre, lorsque le dispositif 1 est dans une configuration assemblée, le capteur 5 est monté sur l'armature 2 en étant aligné avec la base 62. La base 62 est intercalée entre le capteur 5 et la paroi principale 21.

Cela permet notamment de limiter l'encombrement du dispositif 1.

Par exemple, la base 62 présente une forme essentiellement plane. Les parois principales de la base 62 sont alignées parallèlement avec la paroi principale 21. De préférence, la base 62 est maintenue en contact contre la paroi principale 21.

Dans les exemples illustrés, le capteur 5 et le dispositif de stabilisation 6 sont montés sur la deuxième face de la paroi principale 21.

De façon avantageuse, l'épaisseur e62 de la base 62, mesurée selon une direction suivant l'axe X3 lorsque le dispositif 1 est en configuration assemblée, est inférieure ou égale à 5mm ou, de préférence, inférieure ou égale à 3,35mm.

Selon des exemples, le capteur 5 et le dispositif 6 sont installés dans une zone de réception délimitée par des murs de protection 23, 24 électriquement isolants qui s'étendent en saillie perpendiculairement à la paroi principale 21.

Par exemple, les murs de protection 23 et 24 permettent d'augmenter la distance des lignes de fuite dans l'air pour un courant électrique de fuite à l'intérieur du dispositif 1. Le risque d'électrocution d'un utilisateur par un courant électrique de fuite remontant le long de la liaison entre le connecteur 54 et l'unité de commande de l'appareil CB est ainsi réduit.

A titre d'exemple, le capteur 5 et le dispositif 6 sont montés en étant enfilés sur des plots de fixation 25 et en étant maintenus en position par un ou plusieurs éléments de fixation 26 tels que des crochets. Par exemple, les plots de fixation 25 et les éléments 26 font partie de l'armature 2 et s'étendent parallèlement à l'axe X3.

La base 62 comporte un orifice traversant 623 au travers duquel passent les plots de fixation 25. Les crochets 26 engagent les bords du corps 52 du capteur 5 pour le maintenir plaqué contre la base 62 du dispositif 6.

Cela permet de maintenir la base 62 en position de façon stable pour ne pas générer de vibrations supplémentaires. Cela permet aussi de limiter l'encombrement du dispositif 1.

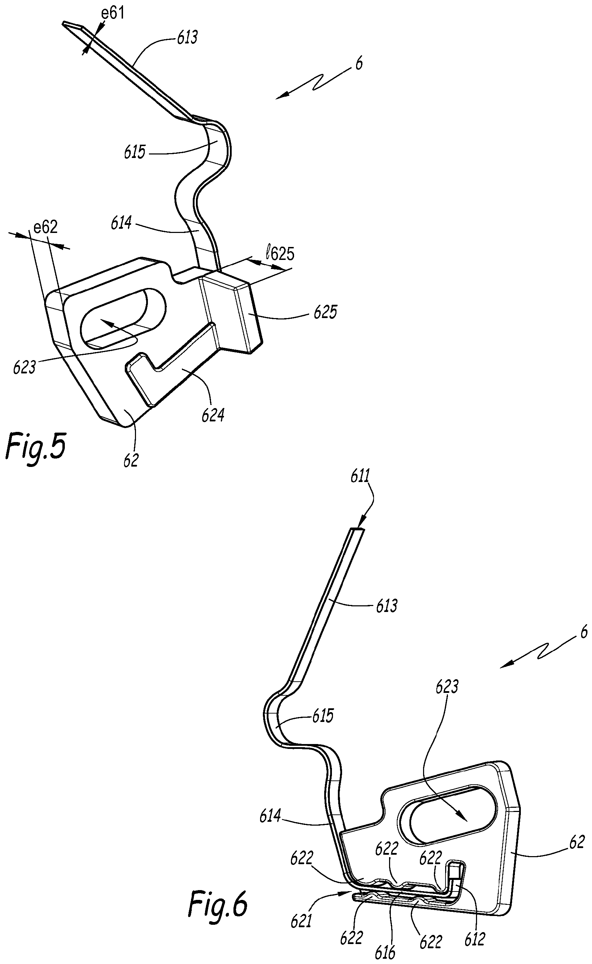

Des modes de réalisation supplémentaires du dispositif 6 sont maintenant décrits plus particulièrement en référence aux figures 5 et 6.

Selon des exemples, la base 62 comporte un logement de réception 621 à l'intérieur duquel est reçue une extrémité de la lame 61. Ainsi, la lame 61 est encastrée dans la base 62 en étant au moins partiellement reçue dans le logement 621.

Dans l'exemple illustré, la partie 616 et l'extrémité 612 sont reçues dans le logement 621. Le logement 621, ici en forme de cavité, présente une forme complémentaire à la portion de lame 61 reçue, par exemple une forme en L. La portion repliée de la deuxième extrémité 612 forme une butée qui empêche le retrait par translation longitudinale de la lame 61 hors du logement 621.

Par exemple, l'ancrage de la lame 61 est réalisé au moyen de points d'appui 622 faisant saillie à l'intérieur du logement 621 depuis la base 62. Les points d'appui 622 sont en contact avec la portion 616. Par exemple, il y a au moins un point d'appui 622 de part et d'autre de la portion 616. Les points d'appui 622 sont ici au nombre de cinq.

Selon des exemples, le logement 621 est ouvert sur une première face de la base 62, cette première face étant tournée vers la paroi principale 21. La lame 61 peut ainsi être insérée facilement dans le logement 621 lors de l'assemblage du dispositif 1. En configuration assemblée du dispositif 1, l'ouverture du logement 621 est fermée par la paroi 21 avec laquelle le dispositif 6 est en contact, empêchant ainsi la lame 61 de sortir du logement 621.

De façon avantageuse, la base 62 comporte une surépaisseur 624 formée sur une deuxième face de la base 62, en regard du logement 621. La deuxième face de la base 62 est opposée à la première face de la base 62. Grâce à la surépaisseur 624, les parois de la base 62 sont suffisamment épaisses pour que la base 62 puisse être démoulée facilement lorsqu'elle est fabriquée par moulage.

Selon des exemples, la base 62 comporte un mur de protection 625 électriquement isolant qui s'étend en saillie par rapport à la deuxième face de la base 62.

Le mur de protection 625 s'étend ici perpendiculairement à la paroi 21 lorsque le dispositif 1 est en configuration assemblée. Par exemple, le mur 625 est parallèle au mur 24 lorsque le dispositif 1 est en configuration assemblée. Le mur 625 est ici venu de matière avec la base 62.

On note « ℓ625 » la longueur du mur de protection 625, mesurée suivant l'axe X3. La longueur ℓ625 est, par exemple, supérieure ou égale à 1cm ou à 2cm. La longueur ℓ625 est, par exemple, inférieure ou égale à 10cm ou à 5cm.

Le mur de protection 625 permet d'augmenter la distance des lignes de fuite dans l'air à l'intérieur du dispositif 1. Le risque d'électrocution d'un utilisateur par des courants de fuite est ainsi réduit.

Les modes de réalisation et les variantes envisagés ci-dessus peuvent être combinés entre eux pour donner naissance à de nouveaux modes de réalisation.

## Revendications

1. Dispositif de mesure (1) pour détecter l'état d'un appareil de commutation électrique (CB), ce dispositif de mesure comportant :
- une armature (2) comprenant une paroi principale (21) ;
- une pièce tournante (3) destinée à être couplée mécaniquement à un arbre de commande (S) d'un appareil de commutation électrique (CB) ;
- un barreau (4) mobile en rotation, de façon solidaire avec la pièce tournante (3), entre une première position et une deuxième position, le barreau (4) s'étendant au travers d'une fente (22) ménagée dans la paroi principale (21) ;
- un capteur de position (5) comportant un contact mobile (51) adapté pour être poussé par le barreau (4) dans une position rétractée lorsque le barreau est dans la première position et dans une position relâchée lorsque le barreau est dans la deuxième position ;
ce dispositif de mesure étant **caractérisé en ce qu'**il comporte :
- un dispositif de stabilisation (6) comportant une base (62) solidaire de l'armature et une lame (61) élastique fixée à la base (62), la lame (61) s'étendant le long de la fente (22) et étant agencée pour exercer un effort de retenue sur le barreau (4) lorsqu'il se trouve dans la première position.

2. Dispositif selon la revendication 1, **caractérisé en ce que** la lame (61) comporte une portion recourbée (615) disposée en regard de la fente (22) et formant un espace de retenue du barreau (4) lorsque le barreau est dans la première position.

3. Dispositif selon l'une quelconque des revendications précédentes, **caractérisé en ce que** la base (62) est réalisée en polycarbonate.

4. Dispositif selon l'une quelconque des revendications précédentes, **caractérisé en ce que** la base (62) comporte un logement de réception (621) à l'intérieur duquel est reçue une portion (616, 612) de la lame (61), le logement (621) étant ouvert sur une première face de la base (62) tournée vers la paroi principale (21) de l'armature (2), l'ancrage de la lame étant réalisé au moyen de points d'appui (622) faisant saillie à l'intérieur du logement (621) depuis la base (62).

5. Dispositif selon la revendication 4, **caractérisé en ce que** l'extrémité encastrée de la lame (61) comporte une portion repliée (612).

6. Dispositif selon la revendication 4 ou la revendication 5, **caractérisé en ce que** la base (62) comporte une surépaisseur (624) formée en regard du logement de réception (621) sur une deuxième face de la base opposée à la première face.

7. Dispositif selon l'une quelconque des revendications précédentes, **caractérisé en ce que** la base (62) comporte un mur de protection (625) électriquement isolant faisant saillie par rapport à la base perpendiculairement à la paroi principale (21) de l'armature (2).

8. Dispositif selon l'une quelconque des revendications précédentes, **caractérisé en ce que** le capteur de position (5) est monté sur l'armature (2) en étant aligné avec la base (62) du dispositif de stabilisation (6), la base (62) étant intercalée entre le capteur de position (5) et la paroi principale (21).

9. Dispositif selon l'une quelconque des revendications précédentes, **caractérisé en ce que** la lame (61) comporte une portion (613) d'extrémité libre disposée en regard de la fente (22) et appuyant sur le barreau (4) lorsque le barreau est dans la deuxième position.

10. Dispositif selon l'une quelconque des revendications précédentes, **caractérisé en ce que** la lame (61) est maintenue en contact avec le barreau (4) lorsque le barreau se déplace entre la première position et la deuxième position.

11. Dispositif selon l'une quelconque des revendications précédentes, **caractérisé en ce que** la lame (61) est agencée pour exercer un effort de retenue sur le barreau (4) lorsque le barreau (4) est dans la deuxième position.

12. Appareil de commutation électrique (CB) comportant des contacts électriques séparables, l'appareil comportant un arbre de commande (S) couplé aux contacts électriques séparables pour commuter l'appareil (CB) entre un état électriquement ouvert et un état électriquement fermé, **caractérisé en ce que** l'appareil de commutation comporte en outre un dispositif de mesure (1) selon l'une quelconque des revendications précédentes, le dispositif de mesure (1) étant couplé mécaniquement à l'arbre de commande (S) pour détecter si l'appareil est dans l'état ouvert ou dans l'état fermé.

## Patentansprüche

1. Messvorrichtung (1) zur Erfassung des Zustands eines elektrischen Schaltgeräts (CB), wobei diese Messvorrichtung umfasst:
- einen Rahmen (2), der eine Hauptwand (21) umfasst;
- ein Drehelement (3), das vorgesehen ist, mit einer Achse (S) zur Steuerung einer elektrischen Schaltvorrichtung (CB) mechanisch verbunden zu werden;
- einen mit dem Drehelement (3) verbundenen Stab (4), der zwischen einer ersten und einer zweiten Stellung drehbeweglich ist, wobei der Stab (4) sich durch einen in der Hauptwand (21) eingearbeiteten Spalt (22) erstreckt;
- einen Positionssensor (5), der einen beweglichen Kontakt (51) aufweist, der angepasst ist, von dem Stab (4) in eine zurückgezogenen Position, wenn der Stab in der ersten Stellung ist, und eine entspannte Position, wenn der Stab in der zweiten Stellung ist, geschoben zu werden;
wobei die Messvorrichtung **dadurch gekennzeichnet ist, dass** sie aufweist:
- eine Stabilisierungsvorrichtung (6), die eine mit dem Rahmen verbundene Basis (62) und eine an der Basis (62) befestigte elastische Lamelle (61) aufweist, wobei die Lamelle (61) sich dem Spalt (22) entlang erstreckt und angeordnet ist, eine Haltekraft auf den Stab (4) auszuüben, wenn er sich in der ersten Stellung befindet.

2. Vorrichtung nach Anspruch 1, **dadurch gekennzeichnet, dass** die Lamelle (61) einen gekrümmten Abschnitt (615) aufweist, der dem Spalt (22) gegenüber angeordnet ist und einen Halteraum für den Stab (4) bildet, wenn sich der Stab in der ersten Stellung befindet.

3. Vorrichtung nach einem beliebigen der vorhergehenden Ansprüche, **dadurch gekennzeichnet, dass** die Basis (62) aus Polycarbonat hergestellt ist.

4. Vorrichtung nach einem beliebigen der vorhergehenden Ansprüche, **dadurch gekennzeichnet, dass** die Basis (62) einen Aufnahmeraum (621) aufweist, in dessen Innerem ein Abschnitt (616, 612) der Lamelle (61) aufgenommen ist, wobei der Aufnahmeraum (621) auf einer ersten, zur Hauptwand (21) des Rahmens (2) gerichteten Seite der Basis (62) offen ist, wobei die Verankerung der Lamelle mit Hilfe von Auflagepunkten (622) realisiert wird, die im Inneren des Aufnahmeraums (621) von der Basis (62) vorspringen.

5. Vorrichtung nach Anspruch 4, **dadurch gekennzeichnet, dass** das eingelassene Ende der Lamelle (61) einen umgebogenen Abschnitt (612) aufweist.

6. Vorrichtung nach Anspruch 4 oder Anspruch 5, **dadurch gekennzeichnet ist, dass** die Basis (62) einen Überstand (624) aufweist, der gegenüber dem Aufnahmeraum (621) auf einer der ersten Seite gegenüberliegenden zweiten Seite der Basis gebildet ist.

7. Vorrichtung nach einem beliebigen der vorhergehenden Ansprüche, **dadurch gekennzeichnet, dass** die Basis (62) eine elektrisch isolierende Schutzwand (625) aufweist, die in Bezug auf die Basis senkrecht zur Hauptwand (21) des Rahmens (2) vorspringt.

8. Vorrichtung nach einem beliebigen der vorhergehenden Ansprüche, **dadurch gekennzeichnet, dass** der Positionssensor (5) an dem Rahmen (2) montiert ist und mit der Basis (62) der Stabilisierungsvorrichtung (6) ausgerichtet ist, wobei die Basis (62) zwischen dem Positionssensor (5) und der Hauptwand (21) eingefügt ist.

9. Vorrichtung nach einem beliebigen der vorhergehenden Ansprüche, **dadurch gekennzeichnet, dass** die Lamelle (61) einen Abschnitt (613) mit freiem Ende aufweist, der dem Spalt (22) gegenüber angeordnet ist und sich an dem Stab (4) abstützt, wenn sich der Stab in der zweiten Stellung befindet.

10. Vorrichtung nach einem beliebigen der vorhergehenden Ansprüche, **dadurch gekennzeichnet, dass** die Lamelle (61) in Kontakt mit dem Stab (4) gehalten wird, wenn der Stab sich zwischen der ersten Stellung und der zweiten Stellung bewegt.

11. Vorrichtung nach einem beliebigen der vorhergehenden Ansprüche, **dadurch gekennzeichnet, dass** die Lamelle (61) angeordnet ist, eine Haltekraft auf den Stab (4) auszuüben, wenn sich der Stab (4) in der zweiten Stellung befindet.

12. Elektrisches Schaltgerät (CB), das trennbare elektrische Kontakte aufweist, wobei das Gerät eine mit den trennbaren elektrischen Kontakten gekoppelte Steuerachse (S) aufweist, um das Gerät (CB) zwischen einem elektrisch geöffneten Zustand und einem elektrisch geschlossenen Zustand umzuschalten, **dadurch gekennzeichnet, dass** das Schaltgerät zusätzlich eine Messvorrichtung (1) nach einem beliebigen der vorhergehenden Ansprüche aufweist, wobei die Messvorrichtung (1) mechanisch mit der Steuerachse (S) gekoppelt ist, um zu detektieren, ob sich das Gerät im geöffneten oder im geschlossenen Zustand befindet.

## Claims

1. Measuring device (1) for detecting the state of an electrical switching apparatus (CB), said measuring device comprising:
- an armature (2) comprising a main wall (21);
- a rotating part (3) which is to be mechanically coupled to a control shaft (S) of an electrical switching apparatus (CB);
- a bar (4) which is rotatable, integrally with the rotating part (3), between a first position and a second position, the bar (4) extending through a slot (22) formed in the main wall (21);
- a position sensor (5) comprising a movable contact (51) which is adapted to be pushed by the bar (4) into a retracted position when the bar is in the first position and into a released position when the bar is in the second position;
the measuring device being **characterised in that** it comprises:
- a stabilising device (6) comprising a base (62) secured to the armature and a resilient strip (61) fixed to the base (62), the strip (61) extending along the slot (22) and being arranged to exert a retaining force on the bar (4) when it is in the first position.

2. Device according to claim 1, **characterised in that** the strip (61) comprises a curved portion (615) which is arranged opposite the slot (22) and forms a space for retaining the bar (4) when the bar is in the first position.

3. Device according to any one of the preceding claims, **characterised in that** the base (62) is made of polycarbonate.

4. Device according to any one of the preceding claims, **characterised in that** the base (62) comprises a receiving housing (621) inside which a portion (616, 612) of the strip (61) is received, the housing (621) being open at a first face of the base (62) facing the main wall (21) of the armature (2), anchoring of the strip being effected by means of support points (622) which project inside the housing (621) from the base (62).

5. Device according to claim 4, **characterised in that** the embedded end of the strip (61) comprises a portion (612) that is folded over.

6. Device according to claim 4 or claim 5, **characterised in that** the base (62) comprises an extra thickness (624) formed opposite the receiving housing (621) on a second face of the base that is opposite the first face.

7. Device according to any one of the preceding claims, **characterised in that** the base (62) comprises an electrically insulating protecting wall (625) which projects relative to the base perpendicularly to the main wall (21) of the armature (2).

8. Device according to any one of the preceding claims, **characterised in that** the position sensor (5) is mounted on the armature (2) in alignment with the base (62) of the stabilising device (6), the base (62) being interposed between the position sensor (5) and the main wall (21).

9. Device according to any one of the preceding claims, **characterised in that** the strip (61) comprises a free end portion (613) which is arranged opposite the slot (22) and bears against the bar (4) when the bar is in the second position.

10. Device according to any one of the preceding claims, **characterised in that** the strip (61) is maintained in contact with the bar (4) when the bar moves between the first position and the second position.

11. Device according to any one of the preceding claims, **characterised in that** the strip (61) is arranged to exert a retaining force on the bar (4) when the bar (4) is in the second position.

12. Electrical switching apparatus (CB) comprising separable electrical contacts, the apparatus comprising a control shaft (S) which is coupled to the separable electrical contacts in order to switch the apparatus (CB) between an electrically open state and an electrically closed state, **characterised in that** the switching apparatus further comprises a measuring device (1) according to any one of the preceding claims, the measuring device (1) being mechanically coupled to the control shaft (S) in order to detect whether the apparatus is in the open state or in the closed state.
